# EUROPÄISCHE PATENTSCHRIFT

(11) **EP 4 196 775 B1**
(45) Veröffentlichungstag und Bekanntmachung des Hinweises auf die Patenterteilung: **10.07.2024**
(21) Anmeldenummer: 21748838.6
(22) Anmeldetag: 22.07.2021
(51) Int. Cl.: G01N 22/00

(54) **TEMPERATURKOMPENSIERTES DIELEKTRIZITÄTSWERT-MESSGERÄT**
TEMPERATURE-COMPENSATED DIELECTRIC-CONSTANT MEASURING DEVICE
DISPOSITIF DE MESURE DE CONSTANTE DIÉLECTRIQUE COMPENSÉE EN TEMPÉRATURE

(30) Priorität: 11.08.2020 DE 102020121151
(43) Veröffentlichungstag der Anmeldung: 21.06.2023
(73) Patentinhaber: Endress+Hauser SE+Co. KG, 79689 Maulburg (DE)
(72) Erfinder: OTTERSBACH, Pablo, 45149 Essen (DE); BLÖDT, Thomas, 79585 Steinen (DE)
(74) Vertreter: Büker, Florian
(86) Internationale Anmeldenummer: PCT/EP2021/070505
(87) Internationale Veröffentlichungsnummer: WO 2022/033829

(56) Entgegenhaltungen:
- DE-U1- 202013 102 514
- US-A1- 2009 212 789
- US-A1- 2015 123 688

## Beschreibung

Die Erfindung betrifft ein Messgerät zur Bestimmung eines temperaturkompensierten Dielektrizitätswertes eines Mediums.

In der Automatisierungstechnik, insbesondere zur Prozessautomatisierung werden vielfach Feldgeräte eingesetzt, die zur Erfassung diverser Messgrößen dienen. Bei der zu erfassenden Messgröße kann es sich beispielsweise um einen Füllstand, einen Durchfluss, einen Druck, die Temperatur, den pH-Wert, das Redoxpotential, eine Leitfähigkeit oder den Dielektrizitätswert eines Mediums in einer Prozessanlage handeln. Zur Erfassung der entsprechenden Messwerte umfassen die Feldgeräte jeweils geeignete Sensoren bzw. basieren auf geeigneten Mess-Verfahren. Eine Vielzahl verschiedener Feldgeräte-Typen wird von der Firmen-Gruppe Endress + Hauser hergestellt und vertrieben.

Die Bestimmung des Dielektrizitätswertes (auch bekannt als "*Dielektrizitätszahl"* oder "*Relative Permittivität"*) diverser Medien ist sowohl bei Feststoffen, als auch bei flüssigen und gasförmigen Füllgütern, wie beispielsweise Treibstoffen, Abwässern, Gasen, Gasphasen oder Chemikalien von großem Interesse, da dieser Wert einen zuverlässigen Indikator für Verunreinigungen, den Feuchtegehalt, die Stoffkonzentration bzw. die Stoffzusammensetzung darstellen kann. Mögliche Messprinzipien zur Bestimmung des Dielektrizitätswertes bestehen darin, die Amplitude, die Phasenverschiebung oder die Signal-Laufzeit von Hochfrequenz-Signalen zu messen. Hierbei wird ein Hochfrequenz-Signal mit einer definierten Frequenz bzw. innerhalb eines definierten Frequenzbandes in das Medium eingekoppelt und ein entsprechendes Empfangssignal bezüglich seiner Amplitude, Phasenlage oder Signallaufzeit in Bezug zum ausgesendeten Hochfrequenz-Signal ausgewertet. Dabei bezieht sich der Begriff "*Hochfrequenz-Signal*" im Kontext dieser Patentanmeldung auf entsprechende Signale mit Frequenzen zwischen 10 MHz und 100 GHz.

Ein phasenbasiertes Dielektrizitätswert-Messgerät wird beispielsweise in der Veröffentlichungsschrift DE 10 2017 130728 A1 beschrieben. In diesem Fall wird der Effekt genutzt, dass die Signalgeschwindigkeit des Hochfrequenz-Signals und somit die Phasenlage entlang einer Mess-Sonde vom Dielektrizitätswert desjenigen Mediums abhängt, das entlang der Mess-Sonde vorherrscht. Prinzipiell wird hierbei zwischen einer relativen und einer absoluten Phasenmessung unterschieden, wobei im Falle einer absoluten Phasenmessung zusätzlich eine so genannte Quadranten-Korrektur durchgeführt wird.

US 2015/123688 A1 beschreibt eine Vorrichtung zur temperaturkompensierten Messung eines Dielektrizitätswerts, umfassend ein Koaxialkabel mit integriertem Temperatursensor.

Zur Bestimmung des Dielektrizitätswertes mittels Pulslaufzeit-Messung kann beispielsweise das TDR-Prinzip ("*Time Domain Reflectometry*"; zu Deutsch "*Zeitbereichsreflektometrie*") angewendet werden. Bei diesem Messprinzip sendet der Sensor ein pulsförmiges Hochfrequenz-Signal mit einer Frequenz zwischen 0,1 GHz und 150 GHz entlang einer elektrisch leitfähigen Mess-Sonde aus und misst die Laufzeit des Pulses bis zum Empfang des reflektierten Hochfrequenz-Signals. Dabei wird der Effekt genutzt, dass die Pulslaufzeit abhängig vom Dielektrizitätswert desjenigen Stoffes ist, der die Mess-Sonde umgibt. Beschrieben ist das Funktionsprinzip von TDR-Sensoren beispielsweise in der Veröffentlichungsschrift EP 0622 628 A2. TDR-Sensoren werden in zahlreichen Ausführungsformen beispielsweise von der Firma IMKO Mikromodultechnik GmbH vertrieben. Vorteilhaft an TDR-Sensoren ist außerdem, dass neben dem Dielektrizitätswert potenziell auch der dielektrische Verlustfaktor des Stoffes bestimmt werden kann.

In der Prozessautomation ist der Dielektrizitätswert oftmals bei Anwendungen zu bestimmen, die nicht unter Raumtemperatur ablaufen, wie beispielsweise Feuchte-Messung in der Lebensmittelindustrie. Da der Dielektrizitätswert jedoch vor allem bei wasserhaltigen Medien stark temperaturabhängig ist, erfordert die Dielektrizitätswert-Messung daherje nach Anwendung eine Temperaturkompensation. Insbesondere, um über den Dielektrizitätswert den Feuchtegehalt eines Mediums bestimmen zu können, ist daher eine äußerst präzise und reproduzierbare Temperaturmessung erforderlich. Eine adäquate Temperaturmessung am Medium ist jedoch in der Regel nicht möglich, da eine Integration des Temperatur-Sensors in das Dielektrizitätswert-Messgerät praktisch schwer realisierbar ist: Sofern der Temperatur-Sensor direkt in der Mess-Sonde des Dielektrizitätswert-Messgerätes und somit am Ort des zu untersuchenden Mediums integriert wird, verfälscht dies zumindest bei Hochfrequenz-basierten Messgeräten die Dielektrizitätswert-Messung erheblich. Eine Realisierung des Temperatur-Sensors abseits der Mess-Sonde kann jedoch wiederum zur Folge haben, dass nicht die Temperatur des zu untersuchenden Mediums gemessen wird, sondern beispielsweise die Außentemperatur am Behälter, in dem sich das Medium befindet.

Der Erfindung liegt daher die Aufgabe zugrunde, ein Messgerät zur Bestimmung des Dielektrizitätswertes bereitzustellen, mittels dem der Dielektrizitätswert möglichst genau gemessen und temperaturkompensiert werden kann.

Die Erfindung löst diese Aufgabe durch ein Messgerät zur Bestimmung eines temperaturkompensierten Dielektrizitätswertes eines Mediums, das folgende Komponenten umfasst:
- Eine Mess-Sonde, mit:
   ∘ einem elektrisch leitfähigen Innenleiter, der zumindest in einem Teilbereich entlang einer Achse stabförmig ausgebildet ist,
   ∘ einem um den Innenleiter herum angeordneten Außenleiter, der zumindest eine elektrisch leitfähige Innenwandung aufweist, wobei die Innenwandung derart symmetrisch um die Achse ausgebildet ist, dass sich die Innenwandung entlang der Achse aufweitet,
   ∘ einem Temperatur-Sensor,
      ▪ der in einem ersten Endbereich des Innenleiters, gen welchen sich die Innenwandung des Außenleiters aufweitet, angeordnet ist, und
      ▪ der zumindest zwei elektrische Anschlüsse aufweist, wobei der erste Anschluss auf dem Potential des Innenleiters liegt.

Dabei ist die Mess-Sonde derart ausgelegt, dass der erste Endbereich des Innenleiters, in welchem der Temperatur-Sensor angeordnet ist, bzw. gen welchen sich der Außenleiter aufweitet, im eingebauten Zustand des Messgerätes gen Medium ausgerichtet ist.

Zum Ansteuern der Mess-Sonde umfasst das Messgerät:
- Eine Steuer-/Auswertungs-Einheit, die ausgelegt ist,
   ∘ um über den zweiten Anschluss des Temperatur-Sensors die Temperatur des Mediums zu ermitteln,
   ∘ um in den Innenleiter oder den Außenleiter ein elektrisches Hochfrequenz-Signal einzukoppeln und ein korrespondierendes Empfangssignal zu empfangen, und
   ∘ um anhand der ermittelten Temperatur und anhand des Empfangssignals den Dielektrizitätswert des Mediums temperaturkompensiert zu bestimmen.

Das erfindungsgemäße Messgerät nutzt also einerseits, dass der Ort der Temperaturmessung mit dem Ort der Dielektrizitätswert-Messung zusammenfällt. Andererseits wird die erfindungsgemäße Erkenntnis genutzt, dass die hochfrequenzbasierte Dielektrizitätswert-Messung nicht beeinflusst wird, sofern der Temperatur-Sensor einseitig auf dem Potential des Innenleiters liegt. Hierzu kann der Temperatur-Sensor beispielsweise als kapazitiver Sensor oder als Widerstandsbasierter Sensor, insbesondere als PT1000 konzipiert werden. Hierdurch kann sowohl eine genaue Dielektrizitätswert-Messung, als auch eine genaue Temperatur-Kompensation der Dielektrizitätswert-Messung erreicht werden.

Unter dem Begriff "*Einheit"* wird im Rahmen der Erfindung prinzipiell jede elektronische Schaltung verstanden, die für den angedachten Einsatzzweck geeignet ausgelegt ist. Es kann sich also je nach Anforderung um eine Analogschaltung zur Erzeugung bzw. Verarbeitung entsprechender analoger Signale handeln. Es kann sich jedoch auch um eine Digitalschaltung wie ein FPGA oder ein Speichermedium in Zusammenwirken mit einem Programm handeln. Dabei ist das Programm ausgelegt, die entsprechenden Verfahrensschritte durchzuführen bzw. die notwendigen Rechenoperationen der jeweiligen Einheit anzuwenden. In diesem Kontext können verschiedene elektronische Einheiten des Dielektrizitätswert-Messgerätes im Sinne der Erfindung potenziell auch auf einen gemeinsamen physikalischen Speicher zurückgreifen bzw. mittels derselben physikalischen Digitalschaltung betrieben werden.

Im Rahmen der Erfindung ist es nicht relevant, welches Hochfrequenz-basierte MessPrinzip im Messgerät implementiert ist, um den Dielektrizitätswert zu bestimmen. Beispielsweise kann das Messgerät bzw. die Steuer-/Auswertungs-Einheit ausgelegt sein, um den Dielektrizitätswert des Mediums anhand einer Phasenlage, anhand einer Amplitude und/oder anhand einer Laufzeit, insbesondere einer Gruppenlaufzeit oder einer Phasenlaufzeit, des Empfangssignals, zu bestimmen. Die Steuer-/Auswertungs-Einheit kann jedoch auch entsprechend ausgelegt werden, um den Dielektrizitätswert des Mediums mittels eines Pulslaufzeit-Verfahrens, insbesondere mittels des TDR-Verfahrens oder des FMCW-Verfahrens zu ermitteln.

Die Frequenz des Hochfrequenz-Signals ist prinzipiell in Abhängigkeit des Dielektrizitätswert-Messbereichs zu wählen. Bei einem Messbereich des Dielektrizitätswertes zwischen 1 und 140 (umfasst neben wässrigen Medien Gase mit 1 bis 1,5 und ölige Messmedien mit 2 bis 20) ist die Steuer-/Auswertungs-Einheit entsprechend auszulegen, um das elektrische Hochfrequenz-Signal mit einer Frequenz zwischen 0,1 GHz und 30 GHz zu erzeugen. Bei wässrigen Medien, deren Dielektrizitätswert ca. 80 bis 100 beträgt, ist das Hochfrequenz-Signal vorzugsweise entsprechend mit einer Frequenz zwischen 5 GHz und 8 GHz zu erzeugen und auszuwerten. Die Länge des Innenleiters und die Geometrie des Außenleiters sind diesbezüglich in Abhängigkeit der Frequenz des Hochfrequenz-Signals auszulegen. Dabei kann die Innenwandung des Außenleiters beispielsweise derart symmetrisch um die Achse ausgebildet werden, dass sie sich konisch, exponentiell oder elliptisch entlang der Achse aufweitet, um das Nahfeld des Hochfrequenz-Signals gen Medium zu richten. Damit die Ausbreitung des Feldes gen Medium möglichst nicht beeinflusst wird, kann der Innenleiter und/oder der zweite Anschluss des Temperatur-Sensors über einen dem ersten Endbereich des Innenleiters entgegengesetzten, zweiten Endbereich des Innenleiters mit der Steuer-/Auswertungs-Einheit kontaktiert werden.

Um die Abmessungen der Mess-Sonde ohne Reduktion der Messgenauigkeit verringern zu können, kann zwischen dem Innenleiter und dem Außenleiter außerdem eine elektrisch isolierende Füllung eingebracht werden. Je höher dabei der Dielektrizitätswert der Füllung ist, desto kleiner kann die Mess-Sonde konzipiert werden. Dementsprechend ist es vorteilhaft, wenn die Füllung einen Dielektrizitätswert von mindestens 2 aufweist. Dementsprechend können hierzu beispielsweise Poly-Ethylen, PEEK, PTFE oder Polypropylen als Füllung vergossen werden.

Korrespondierend zu dem erfindungsgemäßen Dielektrizitätswert-Messgerät gemäß einer der zuvor beschriebenen Ausführungsvarianten wird die Aufgabe, die der Erfindung zugrunde liegt, außerdem durch ein entsprechendes Verfahren zum Betrieb des Messgerätes gelöst. Demnach umfasst das Verfahren zumindest folgende Verfahrensschritte:
- Einkoppeln des Hochfrequenz-Signals in die Mess-Sonde,
- Auskoppeln eines entsprechenden Empfangssignals aus der Mess-Sonde,
- Bestimmung des Dielektrizitätswertes anhand zumindest des Empfangssignals,
- Messung der Temperatur mittels des Temperatur-Sensors, und
- Temperaturkompensation des Dielektrizitätswertes anhand der ermittelten Temperatur.

Dabei kann die Temperaturkompensation beispielsweise auf Basis einer Kompensationsfunktion oder anhand einer Look-up Table durchgeführt werden. In diesem Zusammenhang ist es möglich, die Kompensationsfunktion oder einer Look-up Table durch Einlernen bzw. Kalibration des Messgerätes an Medien mit bekannten Dielektrizitätswerten und unter bekannten Temperaturen zu erstellen.

Anhand der nachfolgenden Figuren wird die Erfindung näher erläutert. Es zeigt:
Fig. 1: Ein erfindungsgemäßes Dielektrizitätswert-Messgerät an einem Behälter, und
Fig. 2: eine Querschnitts-Ansicht der Mess-Sonde des Dielektrizitätswert-Messgerätes.

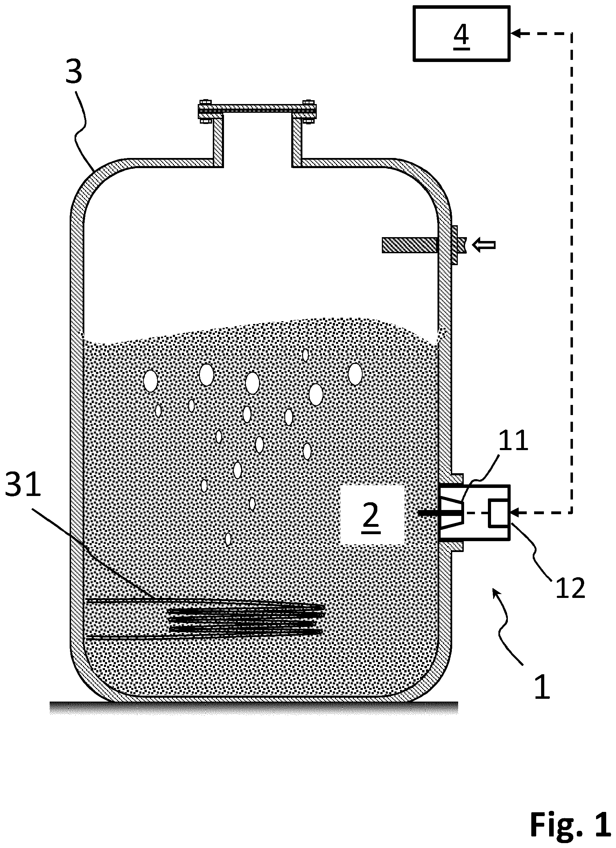

Zum allgemeinen Verständnis des erfindungsgemäßen Dielektrizitätswert-Messgerätes 1 ist in Fig. 1 eine schematische Anordnung des Messgerätes 1 an einem Behälter 3, der mit einem Medium 2 befüllt ist, gezeigt: Zur Bestimmung des Dielektrizitätswertes des Mediums 2 ist das Messgerät 1 seitlich an einem Anschluss des Behälters 3, wie bspw. einem Flanschanschluss befestigt. Optional kann das Messgerät 1 mit einer übergeordneten Einheit 4, wie zum Beispiel einem Prozessleitsystem verbunden sein. Als Schnittstelle kann etwa "PROFIBUS", "HART", "Wireless HART" oder
"Ethernet" implementiert sein. Hierüber kann der Dielektrizitätswert als Betrag, oder komplexwertig mit Realteil und Imaginärteil übermittelt werden. Es können aber auch anderweitige Informationen über den allgemeinen Betriebszustand des Messgerätes 1 kommuniziert werden.

Bei dem Medium 2 kann es sich um Flüssigkeiten wie Getränke, Lacke, Zement oder Treibstoffe, wie Flüssiggase oder Mineralöle handeln. Denkbar ist jedoch auch die Verwendung des Messgerätes 1 bei Schüttgut-förmigen Medien 2, wie bspw. zu trocknendem Getreide. Im Behälter 3 kann das Medium 2 je nach Anwendung neben Trocknungsprozessen auch exothermen Reaktionen, wie Gärprozessen unterzogen werden. Hierzu ist der Behälter 3 gegebenenfalls entsprechend klimatisierbar, beispielsweise mittels eines am Behälter 3 befindlichen Heiz-Elementes 31. Dementsprechend kann die Temperatur des Mediums 2 zumindest während des jeweiligen Prozesses von Raumtemperatur abweichen. Da der Dielektrizitätswert je nach Medium 2 stark temperaturabhängig ist, muss das Messgerät 1 daher ausgelegt sein, den Dielektrizitätswert des Mediums 2 temperaturkompensiert zu bestimmen.

Das erfindungsgemäße Messgerät 1, mittels dem der Dielektrizitätswert temperaturkompensiert ermittelt werden kann, basiert darauf, den Dielektrizitätswert mittels Hochfrequenz-Signalen s_{HF}, r_{HF} zu ermitteln. Dabei können als Messprinzipien zur Bestimmung des Dielektrizitätswertes beispielsweise Laufzeit-basierte Messprinzipien, wie das TDR- oder das FMCW-Verfahren implementiert sein. Daneben können jedoch auch Amplituden- oder Phasen basierte Messprinzipien implementiert werden. Damit das korrespondierende Nahfeld des Hochfrequenz-Signals s_{HF} zur Bestimmung des Dielektrizitätswertes mit dem Medium 2 interagiert, umfasst das Messgerät 1 daher eine gen Medium ausgerichtete Mess-Sonde 11, wie in Fig. 1 schematisch dargestellt ist. Dabei wird die Mess-Sonde 11 von einer Steuer-/Auswertungs-Einheit 12 des Messgerätes 1 angesteuert, indem ein elektrisches Hochfrequenz-Signal s_{HF} in die Mess-Sonde 11 eingekoppelt wird. Somit kann die Steuer-/Auswertungs-Einheit 12 ein entsprechendes Empfangssignal r_{HF} auskoppeln, um darauf basierend den aktuellen, bis dato nicht-temperaturkompensierten Dielektrizitätswert des Mediums 2 zu bestimmen.

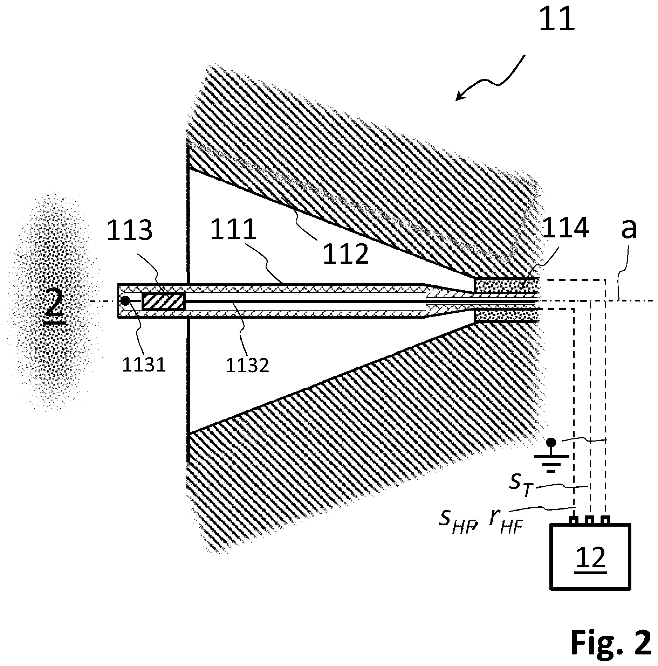

Der erfindungsgemäße Aufbau der Mess-Sonde 11, mittels der eine Temperaturkompensation ermöglicht wird, ist als Querschnittsansicht in Fig. 2 näher verdeutlicht: Kern der Mess-Sonde 11 sind ein elektrisch leitfähiger Innenleiter 111 und ein um den Innenleiter 111 herum angeordneter Außenleiter 112. In die zwei Leiter 111, 112 koppelt die Steuer-/Auswertungs-Einheit 12 das Hochfrequenz-Signal s_{HF} ein, um nach Wechselwirkung mit dem Medium 2 das entsprechende Empfangssignal r_{HF} auskoppeln zu können. Dabei ist es prinzipiell nicht relevant, welcher der beiden Leiter 111, 112 als Signalmasse fungiert. Aus funktioneller Sicht ist es außerdem nicht relevant, ob der Innenleiter 111 und der Außenleiter 112 komplett aus einem elektrisch leitfähigen Material gefertigt sind. Notwendig ist lediglich, dass der Innenleiter 111 in Bezug zum Außenleiter 112 eine elektrisch leitfähige Außenwandung aufweist, und dass der Außenleiter 112 in Bezug zum Innenleiter 111 eine elektrisch leitfähige Innenwandung aufweist. Da es sich bei dem zu untersuchenden Medium 2 auch um hygienisch empfindliche Substanzen handeln kann, ist es jedoch vorteilhaft, zumindest den Innenleiter 111 aus Edelstahl zu fertigen. Sofern nicht auch der Außenleiter komplett aus Edelstahl gefertigt ist, kann die Innenwandung des Außenleiters 112 beispielsweise mittels Sputtern oder mittels eines chemischen Gasphasen-Abscheidungsverfahrens ("*Chemical Vapor Deposition*") metallisch beschichtet werden.

Wie aus Fig. 2 hervorgeht, ist der Innenleiter 111 stabförmig ausgelegt, wobei dessen Querschnitt vorzugsweise rund ist. Dabei bildet der Stab eine geradlinige Achse a, die im montiertem Zustand des Messgerätes 1 gen Medium 2 ausgerichtet ist. Außerdem definiert die Achse a des Innenleiters 111 insofern die Geometrie des Außenleiters 112, als dass die Innenwandung des Außenleiters 112 derart symmetrisch um die Achse a ausgebildet ist, dass sich die Innenwandung des Außenleiters 112 entlang der Achse a gen Medium 2 aufweitet. Dabei ist die Innenwandung des Außenleiters 112 in Bezug zur Achse a wiederum vorzugsweise mit einem runden Querschnitt zu konzipieren.

Bei der in Fig. 2 gezeigten Ausführungsform der Mess-Sonde 11 ist die Aufweitung der Innenwandung des Außenleiters 112 konisch. Allgemein ist die Form bzw. der Öffnungswinkel der Aufweitung derart auf den zu messenden Dielektrizitätswert-Bereich und die Frequenz des Hochfrequenz-Signals s_{HF} anzupassen, dass das Nahfeld des Hochfrequenz-Signals s_{HF} mit maximaler Intensität in das Medium 2 eindringt. Hierdurch wird die Empfindlichkeit der Dielektrizitätswert-Messung maximiert. Dementsprechend kann die Innenwandung des Außenleiters 112 beispielsweise auch elliptisch oder exponentiell aufgeweitet sein.

Ab derjenigen Höhe der Achse a, auf welcher die Aufweitung der Außenleiterinnenwandung entspringt, sind die zwei Leiter 111, 112 durch eine Isolation 114 getrennt. Bei der in Fig. 2 gezeigten Ausführungsvariante erfolgt die elektrische Kontaktierung der zwei Leiter 111, 112 mit der Steuer-/Auswertungs-Einheit 12 über diesen Endbereich. Dabei kann die Isolation 114 beispielsweise auf Basis von PTFE realisiert werden. Durch diese Kabel- bzw. Leiterführung wird vermieden, dass innerhalb des Innenraums zwischen dem Innenleiter 111 und dem Außenleiter 112 innerhalb der Aufweitung etwaige Kabel geführt werden, wodurch wiederum die Empfindlichkeit der Dielektrizitätswert-Messung erhalten bleibt. Optional kann in dem Innenraum zwischen dem Innenleiter 111 und dem Außenleiter 112 außerdem eine elektrisch isolierende Füllung mit einem Dielektrizitätswert größer Eins, beispielsweise aus PEEK eingebracht werden. Hierdurch können die Abmessungen der Mess-Sonde 11 in Bezug auf die Länge und den Durchmesser des Außenleiters 112 reduziert werden, ohne dass die Empfindlichkeit der Dielektrizitätswert-Messung verringert wird.

Zur Temperaturkompensation der Dielektrizitätswert-Messung ist in dem gen Medium 2 zugewandten Endbereich des stabförmigen Innenleiters 111 ein Temperatur-Sensor 113 angeordnet. Bei der in Fig. 2 gezeigten Ausführungsvariante steht der Innenleiter 111 bzw. dessen dem Medium 2 zugewandter Endbereich in Bezug zur Achse a über den Außenleiter 112 hinaus ab. Hierdurch ragt der Temperatursensor 113 im montierten Zustand des Messgerätes 1 über die Behälterwand hinaus in das Medium 2 hinein, so dass die Messung der aktuellen Mediumstemperatur möglichst nicht durch die Behälterwand verfälscht wird. Insbesondere finden die Temperaturmessung und die Dielektrizitätswert-Messung am selben Ort statt, sodass eine von Raumtemperatur abweichende Mediums-Temperatur hinsichtlich des Dielektrizitätswertes unmittelbar in der Steuer-/Auswertungs-Einheit 12 kompensiert werden kann.

Der Temperatur-Sensor 113 kann als kapazitiver Sensor oder als Widerstandsbasierter Sensor, insbesondere als PT1000 ausgelegt sein. Essenziell ist im Rahmen der Erfindung lediglich, dass der Temperatur-Sensor 113, wie in Fig. 2 dargestellt ist, zumindest zwei elektrische Anschlüsse 1131, 1132 aufweist, da einer der zwei Anschlüsse 1131 erfindungsgemäß mit dem Potential des Innenleiters 111 verbunden ist. Als technischer Effekt wird hierdurch vor allem bewirkt, dass nur ein Anschluss 1132 des Temperatur-Sensors 113 aus dem Innenleiter 111 heraus geführt werden muss. Hierdurch kann der Durchmesser des Innenleiters 111 gering gehalten werden, so dass die Impedanz-Anpassung am zweiten Endbereich 114, beispielsweise mit einem 50-Ohm Koaxialkabel vereinfacht wird.

Über den anderen Anschluss 1132 kann die Steuer-Auswertungs-Einheit 12 mittels eines entsprechenden Auswertungssignals s_{T} die Temperatur direkt am Ort des Mediums 2 bestimmen. Hierdurch ist es der Steuer-/Auswertungs-Einheit 12 möglich, anhand der ermittelten Temperatur und anhand des zuvor ermittelten Dielektrizitätswertes des Mediums 2 diesen hinsichtlich der Temperatur sehr genau zu kompensieren, beispielsweise auf Raumtemperatur. Dabei kann die Steuer-/Auswertungs-Einheit 112 die Temperaturkompensation beispielsweise durchführen, indem sie den gemessenen Dielektrizitätswert und die gemessene Temperatur mit einer Look-up table oder einer Kompensationsfunktion abgleicht, die beispielsweise durch Mediums-spezifische Kalibrationsmessungen erhalten wird.

Bei dem in Fig. 2 gezeigten Ausführungsbeispiel der Mess-Sonde 11 wird derjenige Anschluss 1132 des Temperatur-Sensors 113, mittels dem die Steuer-/Auswertungs-Einheit die Temperatur des Mediums 2 ermittelt, über den zweiten Endbereich 114 aus dem Innenleiter 111 aus der Mess-Sonde 11 hinausgeführt. Vorteilhaft an solch einer Führung des Anschlusses 1132 gegenüber einer Führung dieses Anschlusses 1132 über den Innenraum zwischen Innenleiter 111 und Außenleiter 112 ist, dass der Innenraum hochfrequenztechnisch hierdurch nicht gestört wird, so dass die Dielektrizitätswert-Messung nicht beeinträchtigt wird. Eine Führung des zweiten Anschlusses 1132 durch den Innenraum und anschließend durch den Außenleiter 112 aus der Messsonde 11 heraus bietet entgegen der Darstellung in Fig. 2 wiederum den Vorteil einer vereinfachten Fertigbarkeit der Mess-Sonde 11.

### Bezugszeichenliste

- 1: Messgerät
- 2: Medium
- 3: Behälter
- 4: Übergeordnete Einheit
- 11: Mess-Sonde
- 12: Steuer-/Auswertungs-Einheit
- 31: Heiz-Element
- 111: Innenleiter
- 112: Außenleiter
- 113: Temperatur-Sensor, Erster Endbereich
- 114: Zweiter Endbereich, Isolation
- 1131: Erster Anschluss
- 1132: Zweiter Anschluss
- r_{HF}: Empfangssignal
- s_{HF}: Hochfrequenz-Signal
- s_{T}: Signal des Temperatur-Sensors

## Patentansprüche

1. Messgerät zur Bestimmung eines temperaturkompensierten Dielektrizitätswertes eines Mediums (2), umfassend:
- Eine Mess-Sonde (11), mit:
∘ einem elektrisch leitfähigen Innenleiter (111), der zumindest in einem Teilbereich entlang einer Achse (a) stabförmig ausgebildet ist,
∘ einem um den Innenleiter (111) herum angeordneten Außenleiter (112), der zumindest eine elektrisch leitfähige Innenwandung aufweist, wobei die Innenwandung derart symmetrisch um die Achse (a) ausgebildet ist, dass sich die Innenwandung entlang der Achse (a) aufweitet,
∘ einem Temperatur-Sensor (113),
▪ der in einem ersten Endbereich des Innenleiters (111), gen welchen sich die Innenwandung des Außenleiters (112) aufweitet, angeordnet ist,
▪ der zumindest zwei elektrische Anschlüsse (1131, 1132) aufweist, wobei der erste Anschluss (1131) auf dem Potential des Innenleiters (111) liegt,
wobei die Mess-Sonde (11) derart ausgelegt ist, dass der erste Endbereich des Innenleiters (111), in welchem der Temperatur-Sensor (113) angeordnet ist, im eingebauten Zustand des Messgerätes (1) gen Medium (2) ausgerichtet ist,
- eine Steuer-/Auswertungs-Einheit (12), die ausgelegt ist,
∘ um über den zweiten Anschluss (1132) des Temperatur-Sensors (113) die Temperatur des Mediums (2) zu ermitteln,
∘ um in den Innenleiter (111) oder den Außenleiter (112) ein elektrisches Hochfrequenz-Signal (s_{HF}) einzukoppeln und ein korrespondierendes Empfangssignal (r_{HF}) zu empfangen, und
∘ um anhand der ermittelten Temperatur und anhand des Empfangssignals (r_{HF}) den Dielektrizitätswert des Mediums (2) temperaturkompensiert zu bestimmen.

2. Messgerät nach Anspruch 1, wobei die Steuer-/Auswertungs-Einheit (12) ausgelegt ist, den Dielektrizitätswert des Mediums (2) anhand einer Phasenlage, anhand einer Amplitude und/oder anhand einer Laufzeit, insbesondere einer Gruppenlaufzeit oder einer Phasenlaufzeit, des Empfangssignals (r_{HF}), zu bestimmen.

3. Messgerät nach Anspruch 1, wobei die Steuer-/Auswertungs-Einheit (12) ausgelegt ist, den Dielektrizitätswert des Mediums (2) mittels eines Pulslaufzeit-Verfahrens, insbesondere mittels des TDR-Verfahrens oder des FMCW-Verfahrens zu ermitteln.

4. Messgerät nach zumindest einem der vorhergehenden Ansprüche, wobei die Innenwandung des Außenleiters (112) derart symmetrisch um die Achse (a) ausgebildet ist, dass sie sich konisch, exponentiell oder elliptisch entlang der Achse (a) aufweitet.

5. Messgerät nach einem der vorhergehenden Ansprüche, wobei der Temperatur-Sensor (113) als kapazitiver Sensor oder als Widerstandsbasierter Sensor, insbesondere als PT1000 realisiert ist.

6. Messgerät nach zumindest einem der vorhergehenden Ansprüche, wobei die Steuer-/Auswertungs-Einheit (12) ausgelegt ist, das elektrische Hochfrequenz-Signal (s_{HF}) mit einer Frequenz zwischen 0,1 GHz und 30 GHz, vorzugsweise zwischen 5 GHz und 8 GHz, zu erzeugen und auszuwerten.

7. Messgerät nach zumindest einem der vorhergehenden Ansprüche, wobei der Innenleiter (111) und/oder der zweite Anschluss (1132) des Temperatur-Sensors (113) über einen dem ersten Endbereich des Innenleiters (111) entgegengesetzten, zweiten Endbereich (114) des Innenleiters (111) mit der Steuer-/Auswertungs-Einheit (12) kontaktiert sind/ist.

8. Messgerät nach einem der vorhergehenden Ansprüche, wobei zwischen dem Innenleiter (111) und dem Außenleiter (112) eine elektrisch isolierende Füllung mit einem Dielektrizitätswert von insbesondere größer als 2 eingebracht ist.

9. Verfahren zur Bestimmung des temperaturkompensierten Dielektrizitätswertes eines Mediums (2) mittels des Messgerätes (1) nach einem der vorhergehenden Ansprüche, folgende Verfahrensschritte umfassend:
- Einkoppeln des Hochfrequenz-Signals (s_{HF}) in die Mess-Sonde (11),
- Auskoppeln eines entsprechenden Empfangssignals (r_{HF}) aus der Mess-Sonde (11),
- Bestimmung des Dielektrizitätswertes anhand zumindest des Empfangssignals (r_{HF}),
- Messung der Temperatur mittels des Temperatur-Sensors (113), und
- Temperaturkompensation des Dielektrizitätswertes anhand der ermittelten Temperatur.

## Claims

1. A measuring device for determining a temperature-compensated dielectric value of a medium (2), comprising:
- A measuring probe (11), with:
∘ an electrically conductive inner conductor (111), which is rod-shaped along an axis (a) at least in a partial area,
∘ an outer conductor (112) which is arranged around the inner conductor (111) and has at least one electrically conductive inner wall, the inner wall being formed symmetrically about the axis (a) in such a way that the inner wall widens along the axis (a),
∘ a temperature sensor (113),
▪ which is arranged in a first end region of the inner conductor (111), towards which the inner wall of the outer conductor (112) expands,
▪ which has at least two electrical connections (1131, 1132), the first connection (1131) being at the potential of the inner conductor (111),
wherein the measuring probe (11) is designed such that the first end region of the inner conductor (111), in which the temperature sensor (113) is arranged, is aligned towards the medium (2) when the measuring device (1) is installed,
- a control/evaluation unit (12), which is designed,
∘ to determine the temperature of the medium (2) via the second connection (1132) of the temperature sensor (113),
∘ to couple a high-frequency electrical signal (s_{HF} ) into the inner conductor (111) or the outer conductor (112) and to receive a corresponding received signal (r_{HF} ), and
∘ in order to determine the dielectric value of the medium (2) in a temperature-compensated manner using the determined temperature and the received signal (r )._{HF}

2. Measuring device according to claim 1, wherein the control/evaluation unit (12) is designed to determine the dielectric value of the medium (2) on the basis of a phase position, on the basis of an amplitude and/or on the basis of a transit time, in particular a group transit time or a phase transit time, of the received signal (r_{HF} ).

3. Measuring device according to claim 1, wherein the control/evaluation unit (12) is designed to determine the dielectric value of the medium (2) by means of a pulse transit time method, in particular by means of the TDR method or the FMCW method.

4. The measuring device according to at least one of the preceding claims, wherein the inner wall of the outer conductor (112) is formed symmetrically about the axis (a) such that it widens conically, exponentially or elliptically along the axis (a).

5. Measuring device according to one of the preceding claims, wherein the temperature sensor (113) is realized as a capacitive sensor or as a resistance-based sensor, in particular as a PT1000.

6. Measuring device according to at least one of the preceding claims, wherein the control/evaluation unit (12) is designed to generate and evaluate the electrical high-frequency signal (s_{HF} ) with a frequency between 0.1 GHz and 30 GHz, preferably between 5 GHz and 8 GHz.

7. Measuring device according to at least one of the preceding claims, wherein the inner conductor (111) and/or the second connection (1132) of the temperature sensor (113) are/is contacted with the control/evaluation unit (12) via a second end region (114) of the inner conductor (111) opposite the first end region of the inner conductor (111).

8. Measuring device according to one of the preceding claims, wherein an electrically insulating filling with a dielectric value of in particular greater than 2 is introduced between the inner conductor (111) and the outer conductor (112).

9. Method for determining the temperature-compensated dielectric value of a medium (2) by means of the measuring device (1) according to one of the preceding claims, comprising the following method steps:
- Coupling the high-frequency signal (s_{HF} ) into the measuring probe (11),
- Coupling out a corresponding received signal (r_{HF} ) from the measuring probe (11),
- Determination of the dielectric value using at least the received signal (r_{HF} ),
- measuring the temperature by means of the temperature sensor (113), and
- Temperature compensation of the dielectric value based on the determined temperature.

## Revendications

1. Appareil de mesure pour déterminer une valeur de diélectricité compensée en température d'un milieu (2), comprenant :
- Une sonde de mesure (11), avec :
∘ un conducteur intérieur (111) électriquement conducteur, qui est réalisé en forme de barreau au moins dans une zone partielle le long d'un axe (a),
∘ un conducteur extérieur (112) disposé autour du conducteur intérieur (111), qui présente au moins une paroi intérieure électriquement conductrice, la paroi intérieure étant réalisée de manière symétrique autour de l'axe (a) de telle sorte que la paroi intérieure s'élargit le long de l'axe (a),
∘ un capteur de température (113),
▪ qui est disposé dans une première zone d'extrémité du conducteur intérieur (111), vers laquelle la paroi intérieure du conducteur extérieur (112) s'élargit,
▪ qui comporte au moins deux bornes électriques (1131, 1132), la première borne (1131) étant au potentiel du conducteur interne (111),
la sonde de mesure (11) étant conçue de telle sorte que la première zone d'extrémité du conducteur intérieur (111), dans laquelle est disposé le capteur de température (113), est orientée vers le milieu (2) lorsque l'appareil de mesure (1) est monté,
- une unité de commande/d'évaluation (12) qui est conçue
∘ pour déterminer la température du milieu (2) par l'intermédiaire du deuxième raccordement (1132) du capteur de température (113),
∘ pour coupler un signal électrique à haute fréquence (s_{HF} ) dans le conducteur intérieur (111) ou le conducteur extérieur (112) et pour recevoir un signal de réception correspondant (r_{HF} ), et
∘ pour déterminer, à l'aide de la température déterminée et à l'aide du signal de réception (r_{HF} ), la valeur diélectrique du milieu (2) compensée en température.

2. Appareil de mesure selon la revendication 1, dans lequel l'unité de commande/d'évaluation (12) est conçue pour déterminer la valeur diélectrique du milieu (2) à l'aide d'une position de phase, à l'aide d'une amplitude et/ou à l'aide d'un temps de propagation, notamment un temps de propagation de groupe ou un temps de propagation de phase, du signal de réception (r_{HF} ).

3. Appareil de mesure selon la revendication 1, dans lequel l'unité de commande/d'évaluation (12) est conçue pour déterminer la valeur diélectrique du milieu (2) au moyen d'un procédé de temps de transit des impulsions, en particulier au moyen du procédé TDR ou du procédé FMCW.

4. Appareil de mesure selon au moins l'une des revendications précédentes, dans lequel la paroi interne du conducteur externe (112) est symétrique autour de l'axe (a) de telle sorte qu'elle s'évase de manière conique, exponentielle ou elliptique le long de l'axe (a).

5. Appareil de mesure selon l'une des revendications précédentes, dans lequel le capteur de température (113) est réalisé sous la forme d'un capteur capacitif ou d'un capteur à base de résistance, en particulier un capteur PT1000.

6. Appareil de mesure selon au moins l'une des revendications précédentes, dans lequel l'unité de commande/évaluation (12) est adaptée pour générer et évaluer le signal électrique haute fréquence (s_{HF} ) ayant une fréquence comprise entre 0,1 GHz et 30 GHz, de préférence entre 5 GHz et 8 GHz.

7. Appareil de mesure selon au moins l'une des revendications précédentes, dans lequel le conducteur interne (111) et/ou la deuxième connexion (1132) du capteur de température (113) sont/seront en contact avec l'unité de commande/d'évaluation (12) par l'intermédiaire d'une deuxième zone d'extrémité (114) du conducteur interne (111), opposée à la première zone d'extrémité du conducteur interne (111).

8. Appareil de mesure selon l'une des revendications précédentes, dans lequel un remplissage électriquement isolant ayant une valeur diélectrique notamment supérieure à 2 est introduit entre le conducteur interne (111) et le conducteur externe (112).

9. Procédé pour déterminer la valeur diélectrique compensée en température d'un milieu (2) au moyen de l'appareil de mesure (1) selon l'une des revendications précédentes, comprenant les étapes de procédé suivantes :
- Couplage du signal haute fréquence (s_{HF} ) dans la sonde de mesure (11),
- l'extraction d'un signal de réception correspondant (r_{HF} ) de la sonde de mesure (11),
- détermination de la valeur diélectrique à l'aide d'au moins le signal de réception (r_{HF} ),
- mesure de la température au moyen du capteur de température (113), et
- Compensation de la température de la valeur diélectrique à l'aide de la température déterminée.
